# EUROPÄISCHE PATENTSCHRIFT

(11) **EP 1 260 128 B1**
(45) Veröffentlichungstag und Bekanntmachung des Hinweises auf die Patenterteilung: **03.05.2006**
(21) Anmeldenummer: 01915044.0
(22) Anmeldetag: 28.02.2001
(51) Int. Cl.: H05K 13/08, H05K 13/02

(54) **VERFAHREN UND VORRICHTUNG ZUR BESTIMMUNG DER ABHOLLAGE VON ELEKTRISCHEN BAUTEILEN IN EINER BESTÜCKVORRICHTUNG**
METHOD AND DEVICE FOR DETERMINING THE PICK-UP POSITION OF ELECTRICAL COMPONENTS IN A COMPONENT PLACEMENT DEVICE
PROCEDE ET DISPOSITIF PERMETTANT DE DETERMINER LA POSITION DE PRELEVEMENT DE COMPOSANTS ELECTRIQUES DANS UN DISPOSITIF A PLANTER LES COMPOSANTS

(30) Priorität: 01.03.2000 DE 10009765
(43) Veröffentlichungstag der Anmeldung: 27.11.2002
(73) Patentinhaber: SIEMENS AKTIENGESELLSCHAFT, 80333 München (DE)
(72) Erfinder: BACHTHALER, Thomas, 82131 Stockdorf (DE); GRASMÜLLER, Hans, 82291 Mammendorf (DE); LIEBEKE, Thomas, 83059 Kolbermoor (DE); SCHWIEFERT, Michael, 81379 München (DE)
(86) Internationale Anmeldenummer: PCT/DE2001/000740
(87) Internationale Veröffentlichungsnummer: WO 2001/065904

(56) Entgegenhaltungen:
- DE-A- 19 610 126

## Beschreibung

Die Erfindung bezieht sich auf ein Verfahren und eine Vorrichtung zur Bestimmung der Abhollage von elektrischen Bauteilen in einer Bestückvorrichtung zum Bestücken von Substraten mit den Bauteilen, die in Taschen zumindest eines Gurtes bereitgestellt werden, wobei der Gurt in ein Zuführmodul eingeführt wird, das die Bauteile zu einer Abholstelle in eine definierte Abhollage fördert.

Derartige Zuführmodule sind üblicherweise mit einem Stachelrad versehen, das mit seinen radial abstehenden Stiften in Transportlöcher des Gurtes eingreift und das in definierten Winkelschritten entsprechend dem Teilungsabstand der Taschen des Gurtes verdreht wird. Die Taschen weisen eine definierte Lagebeziehung zu den Transportlöchern auf. Auf den Zuführmodulen werden am Ende des Herstellprozesses im Bereich der Abholstelle Zentriermarken angebracht, die in einer definierten Lagebeziehung zu den Stiften des Stachelrades stehen und die Fertigungstoleranzen ausgleichen sollen,

Die Zuführmodule werden in einer definierten Lage auf einem Bauteiletisch befestigt. Da die Zentriermittel hierfür nur in einiger Entfernung von den Abholstellen vorgesehen werden können, kann es es zu Lageabweichungen bei den Zentriermarken kommen. Ein Bestückkopf zum Handhaben der Bauteile ist mit der CCT-Kamera versehen, die zur Ermittlung der genauen Lage des zu bestückenden Substrates in der Bestückvorrichtung dient. Um die erwähnten Lageabweichungen berücksichtigen zu können, ist es üblich, nach dem Einbau des Zuführmoduls die Lage der Zentriermarken auf dem Zuführmodul mittels dieser Leiterplattenkamera zu ermitteln, womit infolge der definierten Lagebeziehungen auch die Lage des abzuholenden Bauteiles bestimmbar ist. Betriebsbedingte Abweichungen im Antriebssystem sind dabei nicht vollständig zu eliminieren.

Im Zuge moderner Technologien werden die zu bestückenden Bauteile immer mehr miniaturisiert. Es ist üblich, den Bestückkopf mit einem Sauggreifer zu versehen, der auf die abzuholenden Bauteile aufgesetzt wird und diese an seiner Stirnseite ansaugt. Dabei muß der Greifer in die Tasche eintauchen, um auf das Bauteil aufsetzen zu können. Die zulässigen Toleranzen zwischen dem Transportloch und der Tasche sind so groß, daß der abholende Sauggreifer nicht mit Sicherheit genau auf das abzuholende Bauteil eingestellt werden kann und auf den Taschenrand aufsetzt und dadurch das Bauteil verfehlt. Hierbei handelt es sich allerdings zumindest über einen längeren Abschnitt des Gurtes um einen systematischen Fehler.

Es ist üblich, bei jedem der abgeholten Bauteile deren Lage gegenüber dem Sauggreifer zu vermessen und das Bauteil mit einem entsprechenden Korrekturwert auf das Substrat aufzusetzen. Um den systematischen Fehler ermitteln zu können, wurden zumindest nach einem Gurtwechsel eine Reihe von Bauelementen des Gurtanfangs entnommen und vermessen und eine mittlere Abweichung vermittelt. Problematisch ist dies aber dann, wenn beim ersten Abholversuch das Bauteil nicht getroffen wird. Dann muß der Greifer im erwähnten Toleranzbereich schrittweise so lange verfahren werden, bis er das Bauteil findet.

Ferner ist durch die US 6 154 957 A eine Bestückvorrichtung mit einem Bestückkopf bekannt geworden, an dem eine zu den Abholstellen der Bauelemente weisende Kamera befestigt ist. Diese wird nach Spalte 3, Zeile 15 bis 19 dazu genutzt, die in den Taschen der Gurte einliegenden Bauelemente optisch zu erfassen und deren Abhollage zu detektieren. Da hierbei offenbar jedes lagekritische Bauelement vor dem Abholen vermessen wird, wird eine höchstmögliche Treffsicherheit erlangt. Da die Kamera und die jeweilige Saugpipette einen Abstand zueinander aufweisen, muß der Bestückkopf jeweils an zwei unterschiedlichen Koordinatenpunkten in zwei Schritten zeitraubend positioniert werden. Ein weiterer Nachteil besteht darin, daß die Tasche üblicherweise an der Entnahmestelle temporär durch einen beweglichen Abdeckschieber verdeckt wird, dessen Betätigung die Zeitspanne für die Abtastung und die Entnahme verringert.

Der Erfindung liegt die Aufgabe zugrunde, die Ermittlung der Abhollage der Bauteile zu beschleunigen.

Diese Aufgabe wird durch die Erfindung gemäß Anspruch 1 gelöst. Die den Taschen zugeordneten Strukturmerkmale z.B. die Ränder der Tasche sind nun unabhängig von der Lagebeziehung zu den Transportlöchern und den Zentriermarken. Die Abtastoptik hat ein so großes Gesichtsfeld, daß sie bereits in der ersten Einstellung die Tasche und deren Umgebungsbereich sicher findet. Die ortsauflösende Abtastoptik übermittelt die gemessenen Werte der elektrischen Auswerteeinheit, die aus den entsprechenden Daten die genaue Mittellage der Taschen berechnet. Der Sauggreifer kann nun sofort sicher auf das abzuholende Bauteil ausgerichtet werden.

Sämtliche Lagetoleranzen zwischen der Bestückvorrichtung und den Zentriermarken sowie zwischen den Zentriermarken und den Transportstiften und zwischen den Transportstiften und den Taschen sind damit ohne Bedeutung und der Sauggreifer kann ohne Fehlversuch mit hoher Genauigkeit auf die Taschenmitte ausgerichtet werden. Das Bauteil wird nun sicher entnommen. Der Bestückvorgang kann nun ohne weiteren Zeitverzug beginnen. Besonders vorteilhaft ist es, die Lage der bereits freigewordenen Nachbartasche zu vermessen, die frei von Störmerkmalen des Bauelements ist. Dabei kann davon ausgegangen werden, daß die Lageabweichung der unmittelbar nachfolgende Tasche vernachlässigbar gering ist. Da die bereits geleerte Tasche vom Abdeckschieber nicht erreicht wird, ist die Tasche jederzeit für die optische Abtastung zugänglich. Ein weiterer Vorteil besteht darin, daß in der Regel die ersten Taschen eines Gurtes von Bauteilen freigelassen werden, so daß für die Vermessung kein Bauteil entfernt werden muss.

Die Gurte und die Bauteile können stark wechselnde optische Eigenschaften aufweisen. Beispielsweise können die Gurte aus durchsichtigem Material bestehen. Aus diesem Grunde kann es erforderlich sein, je nach Gurtart unterschiedliche Strukturmerkmale auszuwählen.

Vorteilhafte Weiterbildungen der Erfindung sind in den Unteransprüchen gekennzeichnet.

Besonders günstig ist es dabei, nach Anspruch 2 die Ränder der Taschen zu ermitteln. Insbesondere bei sehr kleinen Bauteilen ist es üblich, die Taschen aus einem Flachmaterial auszustanzen und bodenseitig durch eine Folie zu verschließen. Diese gestanzten Taschen weisen scharfe definierte Kanten auf, die gut unterscheidbare Strukturmerkmale darstellen.

Durch die Weiterbildung nach Anspruch 3 ist es möglich, die Beleuchtung der Strukturmerkmale auf unterschiedliche Verhältnisse einzustellen, wie dies auch beim Abtasten von Zentriermarkierungen auf den Substraten geschieht. Die Beleuchtung macht es möglich, die Taschen aus unterschiedlichen Richtungen unter unterschiedlichen Winkeln und mit verschiedenen Wellenlängen zu beleuchten, so daß die Strukturmerkmale optimal hervortreten können.

Die Vorrichtung nach Anspruch 4 ermöglicht es, die unterschiedlichen Strukturmerkmale der verschiedenen Gurttypen selbsttätig zu erfassen, wobei jeder volle Gurt, der sich in seinen optischen und geometrischen Eigenschaften von den anderen unterscheidet, einem eigenen Typ zugeordnet wird.

Das Adaptionsmodul nach Anspruch 5 ermöglicht eine optimale Anpassung an die unterschiedlichen optischen Verhältnisse der Gurte.

Im folgenden wird die Erfindung anhand eines in der Zeichnung dargestellten Ausführungsbeispieles näher erläutert.

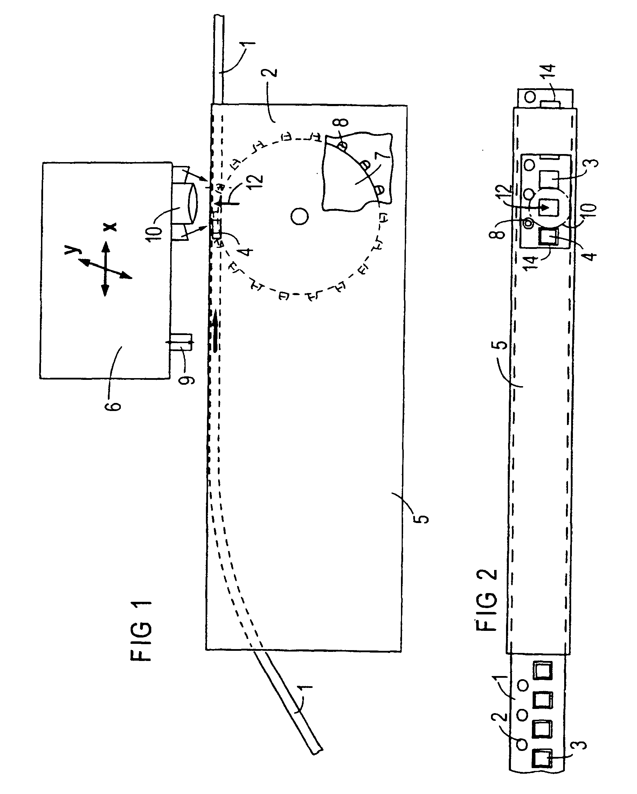

Figur 1 zeigt eine Seitenansicht eines Bestückkopfes und eines Zuführmoduls mit einem Bauteilegurt, Figur 2 eine Draufsicht auf das Zuführmodul nach Figur 1.

Nach den Figuren 1 und 2 ist ein bandartiger Gurt 1 mit seitlichen Transportlöchern 2 und Taschen 3 für darin eingelegte Bauteile 4 versehen und in ein scheibenartiges flaches Zuführmodul 5 eingesetzt, das in einer definierten Lage im Verfahrbereich eines Bestückkopfes 6 einer Bestückvorrichtung fixiert ist. Das Zuführmodul 5 weist ein schrittweise antreibbares Stachelrad 7 mit peripher abstehenden Transportstiften 8 auf, die in die Transportlöcher 2 des Gurtes 1 spielfrei eingreifen. Die Lagebeziehung zwischen den Taschen und den Transportlöchern ist durch einschlägige Normen festgelegt. Die zulässigen Toleranzen sind jedoch hier nahezu so groß wie die Seitenabmessungen der kleinsten Bauteile.

Der Bestückkopf weist auf seiner dem Gurt zugewandten Unterseite einen Sauggreifer 9 und eine Abtastoptik 10 in Form einer CCT-Kamera auf, deren Objektiv von einer Beleuchtung 11 umgeben ist, die das Sichtfeld der Abtastoptik 10 ausleuchtet. Die Beleuchtung 11 kann z.B. aus einer Vielzahl von Leuchtdioden unterschiedlicher Wellenlänge und unterschiedlicher Orientierung bestehen. In Anpassung an die verschiedenen Gurttypen ist es möglich, eine günstige Auswahl der Dioden so anzusteuern, daß die Strukturmerkmale kontrastreich hervortreten und sicher erkannt werden können.

Die Abtastoptik 10 ist auf eine Abholstelle 12 der Bauteile im Zuführmodul 5 gerichtet. Sie ist in der Lage, Strukturmerkmale 14, z.B. die Ränder einer leeren Tasche zu erkennen. Sie ist mit einer Bildauswerteeinheit 13 verbunden, in der anhand dieser Daten die Mittellage der Tasche 3 berechnet wird, so daß das nachfolgende Bauteil 4 vom Sauggreifer sicher erfaßt werden kann, wobei sämtliche Toleranzen eliminiert sind.

Über einen längeren Abschnitt des Gurtes kann sich die Lage der Tasche 3 in bezug auf das Transportloch verändern. In einer nicht dargestellten weiteren optischen Abtasteinheit wird die Lage der entnommenen Bauteile am Sauggreifer 9 zur Erhöhung der Aufsetzgenauigkeit genau vermessen. Die gleitende Lageveränderung der Taschen kann so während des Betriebs sicher erfaßt und berücksichtigt werden, so daß eine Nachvermessung des Gurtes (1) mit Hilfe der Abtastoptik 10 nur nach einem Datenverlust an der Bestückvorrichtung z.B. nach einer Unterbrechung erforderlich werden könnte.

## Patentansprüche

1. Verfahren zur Bestimmung der Abhollage von elektrischen Bauteilen (4) in einer Bestückvorrichtung zum Bestücken von Substraten mit den Bauteilen (4), die in Taschen (3) zumindest eines Gurtes (1) bereitgestellt werden,
wobei der Gurt (3) in ein Zuführmodul (5) eingeführt wird, das die Bauteile (4) zu einer Abholstelle (12) in eine definierte Abhollage fördert,
wobei die Bauteile (4) aus den Taschen (3) mittels eines frei positionierbaren Bestückkopfes (6) entnommen werden,
wobei eine ortsauflösende Abtastoptik (10) des Bestückkopfes (6) über Zentriermarkierungen im Bereich der Abholstelle (12) verfahren wird und deren Lage mit Hilfe einer Bildauswerteeinheit (13) der Bestückvorrichtung ermittelt,
**dadurch gekennzeichnet , daß** die Abtastoptik (10) unmittelbar auf die Taschen (3) gerichtet wird, daß die als die Zentriermarkierungen dienenden Strukturmerkmale (14) der Tasche (3) unmittelbar abgetastet werden und daß die Bildauswerteeinheit (13) die Mittellage der Taschen (3) aus der Lage der Strukturmerkmale (14) berechnet.

2. Verfahren nach Anspruch 1,
**dadurch gekennzeichnet , daß** die Ränder der Tasche (3) erfaßt werden.

3. Verfahren nach Anspruch 1 oder 2,
**dadurch gekennzeichnet , daß** der Abtastoptik (10) eine Beleuchtung (11) zugeordnet ist, deren veränderliche optische Eigenschaften an unterschiedliche Gurttypen angepaßt werden.

4. Vorrichtung zur Durchführung des Verfahrens nach einem der Ansprüche 1 bis 3,
**dadurch gekennzeichnet , daß** eine Steuereinheit der Bestückvorrichtung Steuermittel zur Positionierung der Abtastoptik über der Tasche (3) enthält,
daß Typdaten des Bauteilegurtes der Steuereinheit übermittelbar sind,
daß die Abtastoptik (10) anhand der Typdaten über die Strukturmerkmale des Gurtes (1) verfahrbar ist und
daß die Bildauswerteeinheit (13) mit Mitteln zur Erkennung und Verarbeitung unterschiedlicher Strukturmerkmale der verschiedenen Gurttypen ausgestattet ist.

5. Vorrichtung nach Anspruch 4,
**dadurch gekennzeichnet , daß** die Bildauswerteeinheit (13) und eine Steuerung für die Beleuchtung (11) mit einem selbstlernenden Adaptionsmodul verbunden sind, das die Beleuchtung (11) auf eine hinreichende Kontrastwirkung der Strukturmerkmale einstellt.

## Revendications

1. Procédé permettant de déterminer la position de prélèvement de composants électriques (4) dans un dispositif à planter les composants destiné à équiper des substrats avec les composants (4) qui sont préparés dans des poches (3) d'au moins une courroie (1),
la courroie (3) étant introduite dans un module d'alimentation (5) qui transporte les composants (4) vers un point de prélèvement (12) dans une position de prélèvement définie,
les composants (4) étant prélevés des poches (3) au moyen d'une tête d'équipement (6) positionnable librement,
une optique de lecture (10), à résolution locale, de la tête d'équipement (6) étant déplacée sur des marques de centrage dans la zone du point de prélèvement (12) et la position des marques de centrage étant déterminée à l'aide d'une unité de restitution d'images (13) du dispositif à planter les composants,
**caractérisé en ce que** l'optique de lecture (10) est orientée directement sur les poches (3), **en ce que** les caractéristiques structurales (14) de la poche (3), servant de marques de centrage, sont lues directement et **en ce que** l'unité de restitution d'images (13) calcule la position centrale des poches (3) à partir de la position des caractéristiques structurales (14).

2. Procédé selon la revendication 1,
**caractérisé en ce que** les bords de la poche (3) sont détectés.

3. Procédé selon la revendication 1 ou 2,
**caractérisé en ce qu'**un éclairage (11), dont les propriétés optiques changeantes sont adaptées à différents types de courroies, est affecté à l'optique de lecture (10).

4. Dispositif destiné à la réalisation du procédé selon l'une quelconque des revendications 1 à 3,
**caractérisé en ce qu'**une unité de commande du dispositif à planter les composants comprend des moyens de commande pour le positionnement de l'optique de lecture sur la poche (3),
**en ce que** des données du type de la courroie de composants sont transmissibles à l'unité de commande,
**en ce que** l'optique de lecture (10) est déplaçable sur les caractéristiques structurales de la courroie (1) à l'aide des données du type et
**en ce que** l'unité de restitution d'images (13) est équipée de moyens pour l'identification et le traitement de différentes caractéristiques structurales des différents types de courroie.

5. Dispositif selon la revendication 4,
**caractérisé en ce que** l'unité de restitution d'images (13) et une commande pour l'éclairage (11) sont raccordées à un module d'adaptation à apprentissage automatique, qui règle l'éclairage (11) sur un effet de contraste suffisant des caractéristiques structurales.

## Claims

1. Method of determining the pick-up position of electrical components (4) in a component placement device for populating substrates with the components (4), which are made ready in pockets (3) in at least one belt (1),
the belt (3) being inserted into a feed module (5), which delivers the components (4) to a pick-up point (12) in a defined pick-up position,
the components (4) being removed from the pockets (3) by means of a freely positionable component placement head (6),
position-resolving scanning optics (10) of the component placement head (6) being moved over centring marks in the area of the pick-up point (12) and determined with the aid of an image evaluation unit (13) belonging to the component placement device,
**characterized in that** the scanning optics (10) is aimed directly at the pockets (3), **in that** the structural features (14) of the pocket (3), serving as the centring marks, are scanned directly, and **in that** the image evaluation unit (13) calculates the average position of the pockets (3) from the position of the structural features (14).

2. Method according to Claim 1, **characterized in that** the edges of the pocket (3) are detected.

3. Method according to Claim 1 or 2, **characterized in that** the scanning optics (10) is assigned an illuminating means (11), whose variable optical characteristics are adapted to different belt types.

4. Device for carrying out the method according to one of Claims 1 to 3, **characterized in that** a control unit belonging to the component placement device contains control means for positioning the scanning optics over the pocket (3),
**in that** type data about the component belt can be transmitted to the control unit,
**in that** the scanning optics (10) can be moved over the structural features of the belt (1) by using the type data and
**in that** the image evaluation unit (13) is equipped with means for detecting and processing different structural features of the various belt types.

5. Device according to Claim 4, **characterized in that** the image evaluation unit (13) and a control system for the illuminating means (11) are connected to a self-teaching adaptation module, which adjusts the illumination (11) to a sufficient contrast effect of the structural features.
